# EUROPEAN PATENT SPECIFICATION

(11) **EP 1 143 035 B1**
(45) Date of publication and mention of the grant of the patent: **14.12.2005**
(21) Application number: 01109786.2
(22) Date of filing: 21.05.1996
(51) Int. Cl.: C23C 16/44, C23C 16/48, C23C 16/52, C30B 25/10, H01L 21/00

(54) **Apparatus and method for controlling the temperature of a wall of a reaction chamber**
Verfahren und Vorrichtung zum Regeln der Temperatur einer Reaktorwand
Procédé et dispositif de régulation de la température d'une paroi d'une chambre de réaction

(43) Date of publication of application: 10.10.2001
(62) Divisional of application: 96108108.0
(73) Proprietor: APPLIED MATERIALS, INC., Santa Clara, California 95052 (US)
(72) Inventor: Carlson, David K., Santa Clara, CA 95051 (US); Riley, Norma, Pleasanton, CA 94588 (US); Anderson, Roger N., San Jose, CA 95124 (US)
(74) Representative: Zimmermann, Gerd Heinrich

(56) References cited:
- EP-A- 0 164 928
- EP-A- 0 293 021
- EP-A- 0 467 392
- EP-A- 0 709 488
- US-A- 5 097 890
- US-A- 5 346 555
- PATENT ABSTRACTS OF JAPAN vol. 1995, no. 11, 26 December 1995 (1995-12-26) & JP 07 211663 A (HITACHI LTD), 11 August 1995 (1995-08-11)

## Description

The invention relates to a temperature control apparatus and a concomitant method for controlling the temperature of the walls of a CVD reaction chamber.

In a conventional chemical vapor deposition (CVD) system, a reaction chamber envelopes a volume wherein the deposition process occurs. The chamber typically is fabricated of transparent quartz. As such, the reaction chamber is said to have quartz windows (accessible surfaces of the chamber) through which the temperature of the apparatus within the chamber can be optically monitored using optical pyrometers. In general, since the windows are integral with the walls of the chamber, the temperature of these windows is indicative of the chamber wall temperature. The temperature of the windows and the walls of the chamber vary depending upon the temperature of the workpiece within the chamber, the process presently being accomplished, the gases involved in the current process, and the run time of the process.

More specifically, it is desirable that during a deposition process, the quartz wall temperature be controlled within a narrow temperature range to minimize deposits on the chamber wall. Furthermore, it is desirable that, during cleaning steps, the quartz wall temperature be maintained at a different temperature to maximize the etch rate of any film that may have been deposited on the chamber walls. Such temperature maintenance minimizes particulate contamination problems.

Typically, the temperature of the walls of the chamber is maintained at a nominal value by a flow of air proximate the outer surface of the chamber. This air flow is fixed for each process performed within the chamber. Thus, the temperature of the chamber walls varies with conditions within the chamber, e.g., the wall temperature differs depending on whether the process in the chamber is depositing material or etching material from a workpiece.

Through empirical study, it has been shown that the processes performed within the chamber can be optimized when the chamber wall temperature is maintained at an optimum temperature for a particular process. However, prior art CVD systems contemplate maintaining the air flow past the chamber at a fixed flow rate. As such, these systems exhibit significant chamber wall temperature variations which preclude a high degree of temperature optimization.

Therefore, a need exists in the art for closed loop apparatus, and a concomitant method, for controlling the air flow proximate a reaction chamber such that the temperature of the chamber walls can be readily optimized for each of the processes accomplished within the chamber.

It is the object of the present invention to overcome the above described drawbacks and the disadvantages heretofore associated with prior art CVD systems, and to provide an apparatus and a method which meet the above needs.

According to an object of the present invention it is intended to provide an apparatus and a concomitant method, for controlling the airflow proximate a reaction chamber such that the temperature of the chamber walls can be readily optimized continuously.

This object is solved by the apparatus for controlling the temperature of a wall of a reaction chamber according to independent claim 1, and the method for controlling the temperature of a wall of a reaction chamber according to independent claim 14.

Further advantageous features, aspects and details of the invention are evident from the dependent claims, the description and the drawings. The claims are intended to be understood as a first non-limiting approach of defining the invention in general terms.

Specifically, the present invention provides an apparatus and a concomitant method for controlling coolant flow, preferably air flow, proximate a reaction chamber within a CVD system such that the temperature of the walls of the reaction chamber is maintained at a predefined target temperature. The target temperature is typically a temperature that optimizes a process currently being accomplished within the chamber.

Accordingly, the apparatus for controlling the temperature of a wall of a reaction chamber comprises:
an inlet conduit, connected to a shroud, for carrying a coolant to said shroud, said shroud confines and controls the coolant flow proximate said reaction chamber;
an outlet conduit, connected to said shroud, for exhausting said coolant from said shroud;
a coolant flow control device, located within said inlet conduit, for controlling an amount of coolant that flows into said shroud;
means for measuring a temperature of said wall of said reaction chamber; and
means for controlling said coolant flow control device in response to the measured temperature such that said measured temperature is altered by altering the coolant flow proximate the reaction chamber until the measured temperature attains a target temperature.

According to a second aspect, the apparatus for controlling the temperature of a wall of a reaction chamber provided with a shroud for channeling a coolant stream past said wall comprises
a temperature sensor adjacent said wall for sensing the temperature of the wall and generating a first signal indicative of said sensed wall temperature;
a target temperature signal source for furnishing a second signal indicative of a target wall temperature;
a comparator for accepting said first and second signals and for generating an error signal indicative of the difference between said sensed wall temperature and said target wall temperature;
an adjustable control valve, being responsive to said error signal, for adjusting the degree of closure of said valve and positioned to control the degree of flow of the coolant stream through said shroud, whereby the temperature of the reaction chamber is made to approach the target temperature.

According to a third aspect, the method of controlling the temperature of a wall of a reaction chamber comprises the steps of:
supplying, through an inlet conduit, coolant to a shroud that channels the coolant past said reaction chamber;
exhausting, through an outlet conduit, coolant from said housing after said coolant has flowed past said wall of said reaction chamber;
measuring a temperature of said wall of said reaction chamber;
selecting a target temperature; and
adjusting a coolant flow control device such that the flow of coolant past said wall of said reaction chamber is regulated and said measured temperature becomes substantially equivalent to said target temperature.

According to a fourth aspect, the method for controlling the temperature of a wall of a reaction chamber provided with a shroud for channeling a coolant stream past said wall comprises the steps of:
sensing the temperature of the wall;
generating a first signal indicative of said sensed wall temperature;
furnishing a second signal indicative of a target wall temperature;
comparing said first and second signals;
generating, in response to said comparison, an error signal indicative of the difference between said sensed wall temperature and said target wall temperature;
adjusting, in response to said error signal, the degree of closure of an adjustable control valve that is positioned to control the degree of flow of the coolant stream through the shroud, whereby the temperature of the reaction chamber is made to approach the target temperature.

More specifically, the present invention uses a thermocouple to measure the temperature of a wall of the reaction chamber. The measured temperature is compared to the target temperature. Preferably, a closed loop apparatus controls the air flow past the outer surface of the reaction chamber such that the measured temperature becomes substantially equal to the target temperature. Advantageously, air flow control is provided by a positionable air vane located within an inlet conduit that supplies air to a shroud for channeling air past the reaction chamber. As such, positioning of the air vane regulates the air flow proximate the reaction chamber and, consequently, regulates the temperature of the reaction chamber walls.

In operation, a user can predefine a number of target temperatures that are optimal for particular processes to be performed within the chamber. The apparatus and method according to the present invention adjusts the air flow to achieve and maintain each target temperature during an associated process. Consequently, an optimal reaction chamber wall temperature is used during each process.

The teachings and the background of the present invention can be readily understood by considering the following detailed description in conjunction with the accompanying drawings, in which:
FIG. 1 shows a simplified cross-sectional view of a thermal reaction chamber containing only an optical pyrometer for monitoring the temperature of a wall of the chamber;
FIG. 2 shows a simplified cross-sectional view of a thermal reaction chamber containing a thermocouple for monitoring the temperature of a wall of the chambers (according to the invention);
FIG. 3 depicts a block diagram of circuitry used to provide a closed loop temperature control system; and
FIG. 4 depicts a flow chart of a closed loop control routine.

To facilitate understanding, identical reference numerals have been used, where possible, to designate identical elements that are common to the figures.

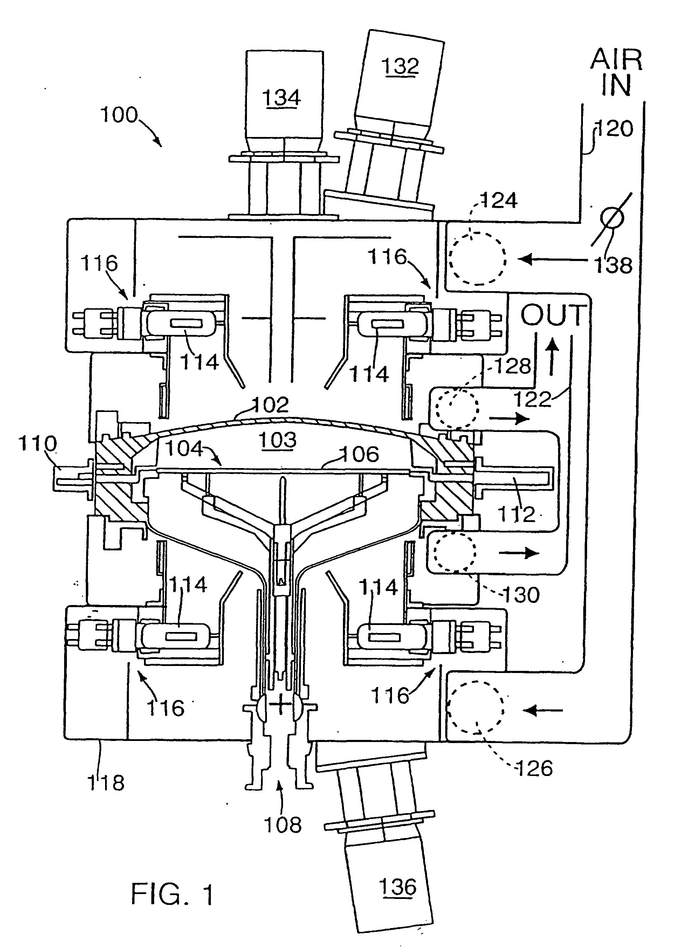

FIG. 1 shows a cross-sectional view of a thermal reaction chamber 102 used in a chemical vapor deposition (CVD) system 100. The chamber has walls that define an inner volume 103 wherein the reactive CVD processes are accomplished. A housing 118 envelopes and supports the chamber 102. Within the inner volume 103 of chamber 102, a workpiece support structure 104 is used to support a workpiece 106 during CVD processing. Such workpiece support structures are generally referred to in the art as susceptors. The workpiece support structure 104 extends through a bottom aperture 108 of the chamber 102. Such an extension enables a drive assembly (not shown) to rotate the workpiece support structure 104, and thus the workpiece 106, during processing. Such rotation is accomplished to enhance process uniformity.

During processing, gases enter the chamber through an entry port 110 and are removed through an exhaust port 112. Also during processing, heat is provided by infrared radiation bulbs 114. The infrared radiation bulbs are mounted, proximate the chamber, on a support assembly 116 connected to a housing 118. The walls of the chamber are transparent, allowing infrared radiation from the radiation bulbs to freely enter the reaction chamber and heat the workpiece.

A more complete description of thermal reactors and their operation is disclosed in commonly assigned U.S. patent 5,258,824 entitled "In-Situ Measurement Of A Thin Film Deposited On A Wafer" and U.S. patent 5,108,792 entitled "Double Dome Reactor for Semiconductor Processing".

During processing, the quartz windows (e.g., accessible portions of the transparent chamber walls), although transparent, still become heated. A coolant flow for cooling the chamber walls is supplied to the housing 118 from a blower (not shown) via inlet conduit 120, directed past the chamber and exhausted through outlet conduit 122. More specifically, the coolant flow is supplied via conduit 120 to housing 118 through upper and lower inlet ports 124 and 126. The coolant flow exits the housing 118 through upper and lower exhaust ports 128 and 130. The housing 118 forms a shroud that channels the coolant past the chamber walls. This constant flow of coolant proximate an outer surface of the chamber cools the walls of the chamber 102. Typically, the coolant is air. An air vane 138 or other coolant flow control device, located in the inlet conduit 120, controls the amount of air flow to the housing and, in turn, controls the temperature of the walls of the chamber. Alternatively, other devices for controlling the coolant flow may be used, such as an adjustable iris, a valve, blower speed control circuitry and the like.

In a parallel application the temperature of the quartz chamber walls is monitored using a conventional optical pyrometer 132. This optical pyrometer should be capable of measuring temperatures in the range of 100 degrees centigrade to 800 degrees centigrade and of detecting a wavelength of between 4.8 and 5.2 µm. Such an optical pyrometer is available from Ircon, Inc. having a business address of 7300 North Natchez Avenue, Niles, Illinois 60648, or from Linear Labs, having a business address of 1290 Hammerwood Avenue, Sunnyvale, California 94089. Similar optical pyrometers are used to measure the temperature of the workpiece 106 (pyrometer 134) and to measure the temperature of the workpiece support structure 104 (pyrometer 136). These pyrometers should be able to measure a temperature range of 500 degrees centigrade to 1250 degrees centigrade and detect a wavelength of between two and four µm.

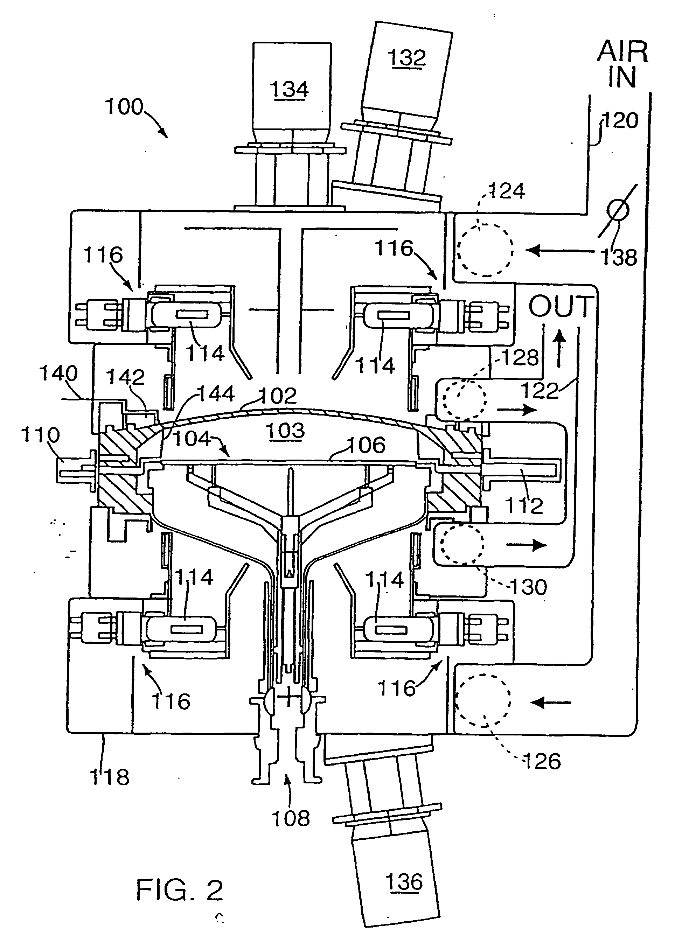

Alternatively, according to the present invention, the temperature measuring device, as shown in FIG. 2, is a shielded thermocouple 140. The thermocouple 140 is attached directly to the outer surface of the reaction chamber 102. Specifically, the thermocouple 140 is mounted under a shield 142 and located directly above an upper quartz liner 144. As such, the temperature of the chamber wall is directly monitored and the thermocouple produces a signal indicative of the measured temperature.

An output signal from the thermocouple 140 is received and processed by signal processing circuitry (not shown). This circuitry may be as simple as a temperature display that converts the electrical output signal from the temperature measuring device into a display of the temperature value represented by the signal, e.g., a light emitting diode or liquid crystal numerical display. An operator, in response to the displayed temperature, manually adjusts the air flow control device such that the air flow across the reaction chamber is altered. In this manner, the operator can adjust the temperature of the chamber walls measured by the thermocouple until the measured temperature is equivalent to a target temperature as indicated on the display. Typically, the target temperature is a temperature that optimizes the present CVD process being accomplished within the chamber.

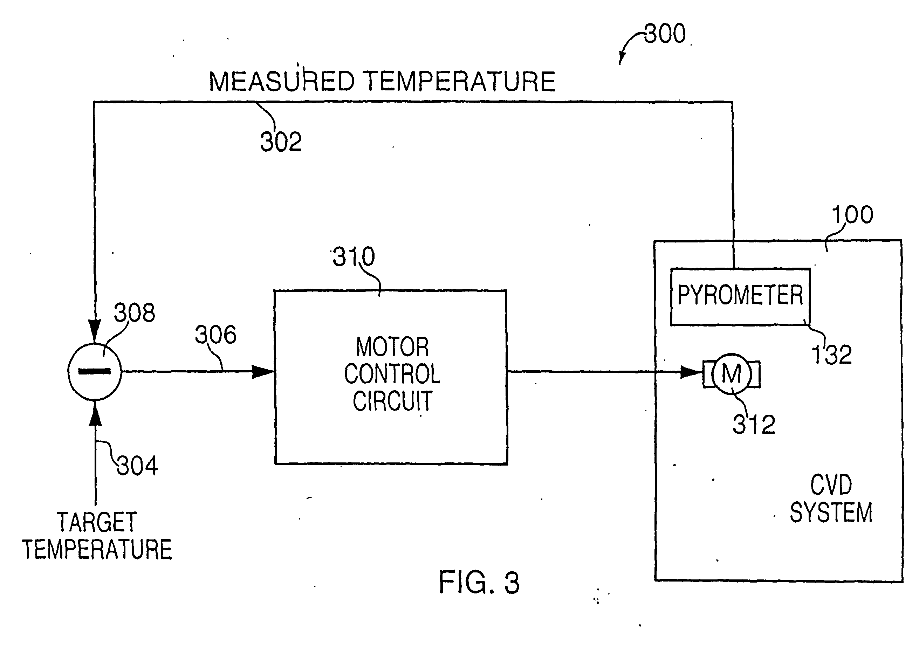

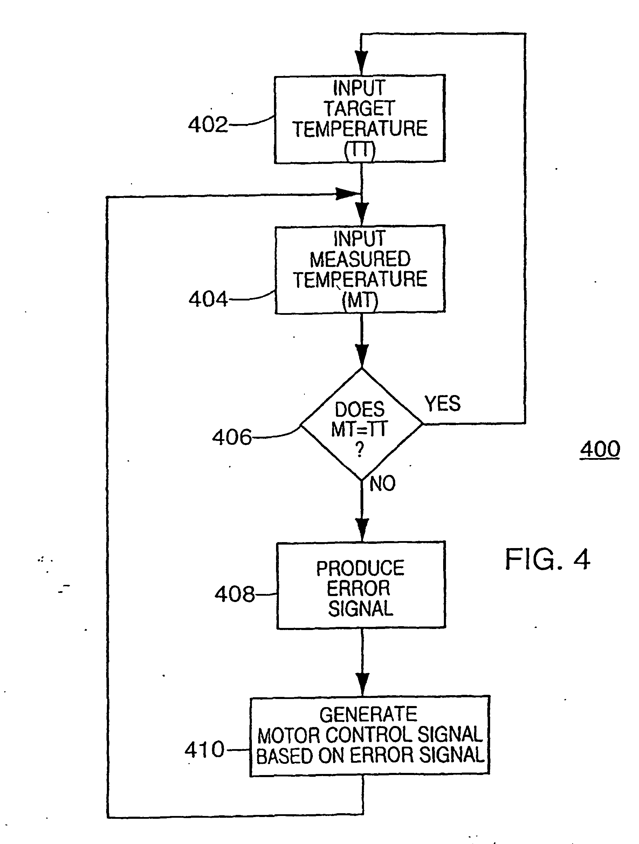

In the foregoing simple implementation of the invention, an operator forms a portion of the closed loop system controlling the measured temperature until attaining a target temperature. Using electrical circuitry, a closed loop circuit can be used to automate this closed loop. In that regard, FIG. 3 depicts a simplified block diagram of a closed loop system that controls the temperature of the chamber walls. FIG. 4 depicts a flow chart of a routine illustrating the process by which this closed loop system functions. To best understand the operation of this closed loop system, the reader should simultaneously refer to both FIGS. 3 and 4.

In this embodiment of the invention, the closed loop system 300 monitors a temperature signal (line 302) generated by the thermocouple, compares, using a subtractor 308, the measured temperature signal to a target temperature value (line 304), and generates an error signal (line 306) representing the difference between the target temperature and the measured temperature. The target temperature could be manually entered into the system or defined by a computer algorithm that is controlling the processing within the chamber. In any event, the error signal forms an input to a motor control circuit 310. The motor control circuit, in response to the error signal, controls a stepper motor 312 that adjusts the air vane. This air vane adjustment moves the air vane such that the error signal is minimized. This entire operation is performed at timed intervals to minimize the error signal and counteract any variation in wall temperature. Consequently, the quartz wall temperature is adjusted to equal the target temperature.

The process involved in this closed loop control of the chamber wall temperature is summarized in the flow chart of FIG. 4. At step 402, the target temperature (TT) is input to the system. At step 404, the measured temperature (MT) is generated by the pyrometer (or thermocouple). At step 406, the routine queries whether the target temperature is equal to the measured temperature. If the temperatures are equal, the routine loops, along YES path 412, to the beginning of the routine and repetitively measures and compares the target and measured temperatures until the query is negatively answered.

If the target and measured temperatures are not equal, the routine proceeds along the NO path emanating from step 406 to step 408. At step 408, the routine produces an error signal by subtracting the measured temperature from the target temperature. At step 410, the motor control circuit generates, in response to the error signal, an appropriate motor control signal. This motor control signal activates the stepper motor and adjusts the position of the air vane. By repeating this routine, the system adjusts the air flow until the target and measured temperatures are equal. Subsequently, the routine continuously monitors the measured temperature and continuously adjusts the air vane position to maintain the measured temperature at the target temperature.

Using this method and system, the temperature of the chamber walls can be set to a target temperature that optimizes the CVD process presently occurring in the chamber. The same system and method maintains that target temperature throughout the process. Subsequently, for other processes, other target temperatures can be selected, established and maintained by the invention.

From the foregoing disclosure, those skilled in the art should realize that the error signal can be used to control other forms of air flow control devices such as blower speed, air valves, adjustable irises, and the like. Additionally, the disclosed routine can be implemented as a software program executed upon a microprocessor (computer) that controls the CVD processing. As such, the microprocessor produces the signals that control the air flow control device.

## Claims

1. Apparatus for controlling the temperature of a wall of a reaction chamber (102) comprising:
an inlet conduit (120), connected to a shroud, for carrying a coolant to said shroud, said shroud confines and controls the coolant flow proximate said reaction chamber(102);
an outlet conduit (122), connected to said shroud, for exhausting said coolant from said shroud;
a coolant flow control device (138), located within said inlet conduit (120), for controlling an amount of coolant that flows into said shroud;
a shielded thermocouple (140) directly attached to the outer surface of the reaction chamber (102) for measuring a temperature of said wall of said reaction chamber (102); and
means (300) for controlling said coolant flow control device (138) in response to the measured temperature such that said measured temperature is altered by altering the coolant flow proximate the reaction chamber (102) until the measured temperature attains a target temperature.

2. The apparatus of claim 1 wherein said shroud forms a portion of a housing (118) for said reaction chamber.

3. The apparatus of claim 1 or 2, wherein said coolant is air.

4. The apparatus of any of the preceding claims wherein said coolant flow control device (138) is an air vane that is selectively positionable to restrict the air flow through said inlet conduit (120) into said shroud.

5. The apparatus of any of the preceding claims further comprising an optical pyrometer (132).

6. The apparatus of any of the preceding claims wherein said means (300) for controlling said coolant flow control device (138) is a closed loop system having said measured temperature and said target temperature as input signals and producing an error signal indicative of the difference between said target temperature and said measured temperature.

7. The apparatus of claim 6 wherein said means (300) for controlling said coolant flow control device (138) adjusts said coolant flow control device (138) in response to said error signal such that said error signal is minimized.

8. The apparatus of claim 6 wherein said means for controlling said coolant flow control device adjusts said vane in response to said error signal such that said error signal is minimized.

9. The apparatus of claim 8 wherein said means (300) for controlling said coolant flow control device (138) further comprises a motor control circuit (310) electrically connected to a stepper motor (312) that selectively positions said air vane, said motor control circuit (310) produces, in response to said error signal, a motor drive signal for positioning said stepper motor (312) such that said air vane is positioned to minimize said error signal.

10. Apparatus according to one of the preceding claims, for controlling the temperature of a wall of a reaction chamber (102), whereby said reaction chamber is provided with said shroud for channeling a coolant stream past said wall and whereby said
shielded thermocouple (140) is adjacent said wall, suitable for sensing the temperature of the wall and generating a first signal indicative of said sensed wall temperature;
the apparatus further comprising:
a target temperature signal source for furnishing a second signal indicative of a target wall temperature; and
a comparator (308) for accepting said first and second signals and for generating an error signal indicative of the difference between said sensed wall temperature and said target wall temperature; whereby said coolant flow control device is an adjustable control valve (138), being responsive to said error signal, for adjusting the degree of closure of said valve and positioned to control the degree of flow of the coolant stream through said shroud, whereby the temperature of the reaction chamber (102) is made to approach the target temperature.

11. The apparatus of claim 10 wherein said adjustable control valve (138) is an air vane that is selectively positionable to restrict the air flow through said shroud.

12. The apparatus of claim 10 or 11 further comprising an optical pyrometer (132).

13. The apparatus of any of the preceding claims wherein the shielded thermocouple is directly attached to the outer surface of the reaction chamber (102), for measuring a temperature of said wall of said reaction chamber (102).

14. A method of controlling the temperature of a wall of a reaction chamber comprising the steps of:
supplying, through an inlet conduit, coolant to a shroud that channels the coolant past said reaction chamber;
exhausting, through an outlet conduit, coolant from said housing after said coolant has flowed past said wall of said reaction chamber;
measuring a temperature of said wall of said reaction chamber with a shielded thermocouple directly attached to the outer surface of the reaction chamber (102);
selecting a target temperature; and
adjusting a coolant flow control device such that the flow of coolant past said wall of said reaction chamber is regulated and said measured temperature becomes substantially equivalent to said target temperature.

15. The method of claim 14 wherein said coolant is air.

16. The method of claim 14 or 15 wherein the shroud is a portion of a housing for said reaction chamber.

17. The method of one of claims 14 to 16 wherein said adjusting step further comprises the steps of:
computing an error signal indicative of the difference between said measured temperature and said target temperature; and
controlling, in response to said error signal, the coolant flow control device such that said error signal is minimized.

18. The method of one of claims 14 to 17 wherein said coolant flow control device is an air vane.

19. The method of claim 18 wherein said computing step further comprises the steps of:
supplying said error signal to a motor control circuit;
generating, within said motor control circuit, a motor control signal that is responsive to said error signal;
activating, in response to said motor control signal, a motor that is coupled to said air vane such that said air vane is positioned to regulate said air flow and minimize said error signal.

20. A method for controlling the temperature of a wall of a reaction chamber according to claim 15, the chamber being provided with a shroud for channeling a coolant stream past said wall, said method further comprising the steps of:
sensing the temperature of the wall with said shielded thermocouple;
generating a first signal indicative of said sensed wall temperature;
furnishing a second signal indicative of said target wall temperature;
comparing said first and second signals;
generating, in response to said comparison, an error signal indicative of the difference between said sensed wall temperature and said target wall temperature; whereby the adjusting of a coolant flow control device is conducted by
adjusting, in response to said error signal, the degree of closure of an adjustable control valve that is positioned to control the degree of flow of the coolant stream through the shroud, whereby the temperature of the reaction chamber is made to approach the target temperature.

21. The method of claim 20 wherein said coolant is air.

22. The method of c la im 20 or 21 wherein the shroud is a portion of a housing for said reaction chamber.

23. The method of one of claims 20 to 22 wherein said adjustable control valve is an air vane.

24. The method of claim 23 wherein said adjusting step further comprises the steps of:
supplying said error signal to a motor control circuit;
generating, within said motor control circuit, a motor control signal that is responsive to said error signal;
activating, in response to said motor control signal, a motor that is coupled to said air vane such that said air vane is positioned to regulate said air flow and minimize said error signal.

## Patentansprüche

1. Vorrichtung zum Steuern der Temperatur einer Wand einer Reaktionskammer (102), umfassend:
einen mit einem Leitblech verbundenen Einlaßkanal (120) zum Heranführen eines Kühlmittels an das Leitblech, wobei das Leitblech den Kühlmittelstrom nahe der Reaktionskammer (102) begrenzt und steuert;
einen mit dem Leitblech verbundenen Auslaßkanal (122) zum Auslassen des Kühlmittels aus dem Leitblech;
ein innerhalb des Einlaßkanals (120) angeordnetes Kühlmittelstrom-Steuergerät (138) zum Steuern einer Menge an Kühlmittel, die in das Leitblech einströmt;
ein direkt and der äußeren Oberfläche der Reaktionskammer (102) angebrachtes abgeschirmtes Thermoelement (140) zum Messen einer Temperatur der Wand der Reaktionskammer (102); und
Mittel (300) zum Steuern des Kühlmittelstrom-Steuergeräts (138) in Antwort auf die gemessene Temperatur, so daß die gemessene Temperatur durch Veränderung des Kühlmittelstroms nahe der Reaktionskammer (102) solange verändert wird bis die gemessene Temperatur eine Zieltemperatur erreicht.

2. Vorrichtung nach Anspruch 1, wobei das Leitblech einen Bereich eines Gehäuses (118) für die Reaktionskammer bildet.

3. Vorrichtung nach Anspruch 1 oder 2, wobei das Kühlmittel Luft ist.

4. Vorrichtung nach einem der vorhergehenden Ansprüche, wobei das Kühlmittelstrom-Steuergerät (138) eine Luftleitschaufel ist, die wahlweise positionierbar ist, um den Luftstrom durch den Einlaßkanal (120) in das Leitblech zu begrenzen.

5. Vorrichtung nach einem der vorhergehenden Ansprüche, weiterhin umfassend ein optisches Pyrometer (132).

6. Vorrichtung nach einem der vorhergehenden Ansprüche, wobei das Mittel (300) zum Steuern des Kühlmittelstrom-Steuergeräts (138) ein geschlossenes Regelsystem ist, das die gemessene Temperatur und die Zieltemperatur als Eingangssignale aufweist und das ein Fehlersignal erzeugt, das für den Unterschied zwischen der Zieltemperatur und der gemessenen Temperatur anzeigend ist.

7. Vorrichtung nach Anspruch 6, wobei das Mittel (300) zum Steuern des Kühlmittelstrom-Steuergeräts (138) das Kühlmittelstrom-Steuergerät (138) in Antwort auf das Fehlersignal so einstellt, daß das Fehlersignal minimiert wird.

8. Vorrichtung nach Anspruch 6, wobei das Mittel zum Steuern des Kühlmittelstrom-Steuergeräts die Luftleitschaufel in Antwort auf das Fehlersignal so einstellt, daß das Fehlersignal minimiert wird.

9. Vorrichtung nach Anspruch 8, wobei das Mittel (300) zum Steuern des Kühlmittelstrom-Steuergeräts (138) weiterhin einen Motorsteuerungs-Schaltkreis (310) umfaßt, der mit einem Schrittmotor (312), der die Luftleitschaufel wahlweise positioniert, elektrisch verschaltet ist, wobei der Motorsteuerungs-Schaltkreis (310) in Antwort auf das Fehlersignal ein Motorantriebssignal zum Positionieren des Schrittmotors (312) erzeugt, so daß die Luftleitschaufel positioniert wird, um das Fehlersignal zu minimieren.

10. Vorrichtung nach einem der vorhergehenden Ansprüche zum Steuern der Temperatur einer Wand einer Reaktionskammer (102), wonach die Reaktionskammer mit dem Leitblech zum Leiten eines Kühlmittelstroms entlang der Wand ausgestattet ist, und wobei das abgeschirmte Thermoelement (140) nahe der Wand in geeigneter Weise angeordnet ist, um die Temperatur der Wand zu erfassen und ein erstes Signal zu erzeugen, das die erfaßte Wandtemperatur anzeigt;
wobei die Vorrichtung weiterhin umfaßt:
eine Zieltemperatursignalquelle zum Liefern eines zweiten Signals, das die Wandzieltemperatur anzeigt; und
ein Vergleicher (308) zum Aufnehmen des ersten und zweiten Signals und zum Erzeugen eines Fehlersignals, das den Unterschied zwischen der erfaßten Wandtemperatur und der Wandzieltemperatur anzeigt; wobei
das Kühlmittelstrom-Steuergerät ein auf das Fehlersignal ansprechendes einstellbares Steuerventil (138) zum Einstellen des Verschlußgrades des Ventils ist und angeordnet ist, um den Grad des Flusses des Kühlmittelstroms durch das Leitblech zu steuern, wodurch erreicht wird, daß die Temperatur der Reaktionskammer (102) sich der Zieltemperatur annähert.

11. Vorrichtung nach Anspruch 10, wobei das einstellbare Steuerventil (138) eine Luftleitschaufel ist, die wählbar positionierbar ist, um den Luftstrom durch das Leitblech zu begrenzen.

12. Vorrichtung nach Anspruch 10 oder 11, weiterhin umfassend ein optisches Pyrometer (132).

13. Vorrichtung nach einem der vorhergehenden Ansprüche, wobei das abgeschirmte Thermoelement zum Messen einer Temperatur der Wand der Reaktionskammer (102) direkt auf der äußeren Oberfläche der Reaktionskammer (102) angebracht ist.

14. Verfahren zum Steuern der Temperatur einer Wand einer Reaktionskammer, umfassend die Schritte:
Bereitstellen von Kühlmittel an ein Leitblech, das das Kühlmittel entlang der Reaktionskammer leitet, durch einen Einlaßkanal;
Auslassen des Kühlmittels aus dem Gehäuse durch einen Auslaßkanal, nachdem das Kühlmittel entlang der Wand der Reaktionskammer geströmt ist;
Messen einer Temperatur der Wand der Reaktionskammer mit einem abgeschirmten Thermoelement, das direkt an der äußeren Oberfläche der Reaktionskammer (102) angebracht ist;
Auswählen einer Zieltemperatur; und
Einstellen eines Kühlmittelstrom-Steuergeräts, so daß der Kühlmittelstrom entlang der Wand der Reaktionskammer geregelt wird und die gemessene Temperatur im wesentlichen gleich der Zieltemperatur wird.

15. Verfahren nach Anspruch 14, wobei das Kühlmittel Luft ist.

16. Verfahren nach Anspruch 14 oder 15, wobei das Leitblech einen Bereich eines Gehäuses für die Reaktionskammer bildet.

17. Verfahren nach einem der Ansprüche 14 bis 16, wobei der Einstellschritt weiterhin die Schritte umfaßt:
Berechnen eines Fehlersignals, das den Unterschied zwischen der gemessenen Temperatur und der Zieltemperatur anzeigt; und
Steuern des Kühlmittelstrom-Steuergeräts in Antwort auf das Fehlersignal, so daß das Fehlersignal minimiert wird.

18. Verfahren nach einem der Ansprüche 14 bis 17, wobei das Kühlmittelstrom-Steuergerät eine Luftleitschaufel ist.

19. Verfahren nach Anspruch 18, wobei der Berechnungsschritt weiterhin umfaßt:
Bereitstellen des Fehlersignals an einen Motorsteuerungs-Schaltkreis;
Erzeugen eines Motorsteuersignals, das auf das Fehlersignal anspricht, in dem Motorsteuerungs-Schaltkreis;
Aktivieren eines mit der Luftleitschaufel gekoppelten Motors in Antwort auf das Motorsteuersignal, so daß die Luftleitschaufel positioniert wird, um den Luftstrom zu regeln und das Fehlersignal zu minimieren.

20. Verfahren zum Steuern der Temperatur einer Wand einer Reaktionskammer gemäß Anspruch 15, wobei die Kammer mit einem Leitblech zum Leiten eines Kühlmittelstroms entlang der Wand ausgestattet ist, wobei das Verfahren weiterhin die Schritte umfaßt:
Erfassen der Temperatur der Wand mit dem abgeschirmten Thermoelement;
Erzeugen eines ersten Signals, das die erfaßte Wandtemperatur anzeigt;
Liefern eines zweiten Signals, das die Zielwandtemperatur anzeigt;
Vergleichen des ersten und des zweiten Signals;
Erzeugen eines Fehlersignals in Antwort auf den Vergleich, das den Unterschied zwischen der erfaßten Wandtemperatur und der Zielwandtemperatur anzeigt; wobei
in Antwort auf das Fehlersignal das Einstellen eines Kühlinittelstrom-Steuergeräts durchgeführt wird durch das Einstellen des Verschlußgrades eines einstellbaren Steuerventils, das angeordnet ist, um den Grad des Flusses eines Kühlmittelstroms durch das Leitblech zu steuern, wodurch erreicht wird, daß die Temperatur der Reaktionskammer sich der Zieltemperatur annähert.

21. Verfahren nach Anspruch 20, wobei das Kühlmittel Luft ist.

22. Verfahren nach Anspruch 20 oder 21, wobei das Leitblech einen Bereich eines Gehäuses für die Reaktionskammer bildet.

23. Verfahren nach einem der Ansprüche 20 bis 22, wobei das Kühlmittelstrom-Steuergerät eine Luftleitschaufel ist.

24. Verfahren nach Anspruch 23, wobei der Einstellschritt weiterhin umfaßt:
Bereitstellen des Fehlersignals an einen Motorsteuerungs-Schaltkreis;
Erzeugen eines Motorsteuersignals, das auf das Fehlersignal anspricht, in dem Motorsteuerungs-Schaltkreis;
Aktivieren eines mit der Luftleitschaufel gekoppelten Motors in Antwort auf das Motorsteuersignal, so daß die Luftleitschaufel positioniert wird, um den Luftstrom zu regeln und das Fehlersignal zu minimieren.

## Revendications

1. Appareil pour la commande de la température d'une paroi d'une chambre de réaction (102), comprenant :
un conduit d'entrée (120), connecté à une enveloppe, pour transporter un réfrigérant vers ladite enveloppe, ladite enveloppe confinant et commandant le flux de réfrigérant à proximité de ladite chambre de réaction (102) ;
un conduit de sortie (122), connecté à ladite enveloppe, pour évacuer ledit réfrigérant depuis ladite enveloppe ;
un dispositif (138) de commande du flux de réfrigérant, situé au sein dudit conduit d'entrée (120), pour commander une quantité de réfrigérant qui pénètre dans ladite enveloppe ;
un thermocouple protégé (140), directement fixé à la surface externe de la chambre de réaction (102), pour mesurer une température de ladite paroi de ladite chambre de réaction (102) ; et
un moyen (300) pour commander ledit dispositif (138) de commande du flux de réfrigérant en réponse à la température mesurée, de telle sorte que ladite température mesurée est modifiée par modification du flux de réfrigérant à proximité de la chambre de réaction (102) jusqu'à ce que la température mesurée atteigne une température cible.

2. Appareil selon la revendication 1, dans lequel ladite enveloppe forme une portion d'un logement (118) pour ladite chambre de réaction.

3. Appareil selon la revendication 1 ou 2, dans lequel ledit réfrigérant est de l'air.

4. Appareil selon l'une quelconque des revendications précédentes, dans lequel ledit dispositif (138) de commande du flux de réfrigérant est un contrôleur de dosage à ailette qui peut être sélectivement positionné pour limiter le flux d'air via ledit conduit d'entrée (120) dans ladite enveloppe.

5. Appareil selon l'une quelconque des revendications précédentes, comprenant, en outre, un pyromètre optique (132).

6. Appareil selon l'une quelconque des revendications précédentes, dans lequel ledit moyen (300) pour commander ledit dispositif (138) de commande du flux de réfrigérant est un système à boucle fermée ayant, comme signaux d'entrée, ladite température mesurée et ladite température cible et produisant un signal d'erreur représentant la différence entre ladite température cible et ladite température mesurée.

7. Appareil selon la revendication 6, dans lequel ledit moyen (300) pour commander ledit dispositif (138) de commande du flux de réfrigérant règle ledit dispositif (138) de commande du flux de réfrigérant en réponse audit signal d'erreur de telle sorte que ledit signal d'erreur soit réduit à un minimum.

8. Appareil selon la revendication 6, dans lequel ledit moyen pour commander ledit dispositif de commande du flux de réfrigérant règle ladite ailette en réponse audit signal d'erreur de telle sorte que ledit signal d'erreur soit réduit à un minimum.

9. Appareil selon la revendication 8, dans lequel ledit moyen (300) pour commander ledit dispositif (138) de commande du flux de réfrigérant comprend, en outre, un circuit de commande moteur (310) connecté électriquement à un moteur pas à pas (312) qui positionne sélectivement ledit contrôleur de dosage à ailette, ledit circuit de commande moteur (310) produisant, en réponse audit signal d'erreur, un signal d'entraînement du moteur pour positionner ledit moteur pas à pas (312) de telle sorte que ledit contrôleur de dosage à ailette soit positionné pour réduire à un minimum ledit signal d'erreur.

10. Appareil selon l'une des revendications précédentes, pour commander la température d'une paroi d'une chambre de réaction (102),
dans lequel ladite chambre de réaction est pourvue de ladite enveloppe pour canaliser un courant de réfrigérant au-delà de ladite paroi et
dans lequel ledit thermocouple protégé (140) est adjacent à ladite paroi, convenant pour détecter la température de la paroi et générer un premier signal représentant ladite température de paroi détectée ;
l'appareil comprenant, en outre :
une source de signal de température cible pour fournir un second signal représentant une température de paroi cible ; et
un comparateur (308) pour accepter lesdits premier et second signaux et générer un signal d'erreur représentant la différence entre ladite température de paroi détectée et ladite température de paroi cible ; appareil dans lequel ledit dispositif de commande du flux de réfrigérant est une valve de commande réglable (138), qui réagit audit signal d'erreur, pour régler le degré de fermeture de ladite valve et qui est positionnée pour commander le degré du flux du courant de réfrigérant au travers de ladite enveloppe, grâce à quoi la température de la chambre de réaction (102) est rapprochée de la température cible.

11. Appareil selon la revendication 10, dans lequel ladite valve de commande réglable (138) est un contrôleur de dosage à ailette qui peut être positionné sélectivement pour limiter le flux d'air au travers de ladite enveloppe.

12. Appareil selon la revendication 10 ou 11, comprenant, en outre, un pyromètre optique (132).

13. Appareil selon l'une quelconque des revendications précédentes, dans lequel le thermocouple protégé est fixé directement à la surface externe de la chambre de réaction (102) pour mesurer une température de ladite paroi de ladite chambre de réaction (102).

14. Procédé de commande de la température d'une paroi d'une chambre de réaction, comprenant les étapes suivantes :
la fourniture, via un conduit d'entrée, d'un réfrigérant à une enveloppe qui canalise le réfrigérant au-delà de ladite chambre de réaction ;
l'évacuation, via un conduit de sortie, du réfrigérant depuis ledit logement après que ledit réfrigérant s'est écoulé au-delà de ladite paroi de ladite chambre de réaction ;
la mesure d'une température de ladite paroi de ladite chambre de réaction avec un thermocouple protégé, fixé directement à la surface externe de la chambre de réaction (102) ;
la sélection d'une température cible ; et
le réglage d'un dispositif de commande du flux de réfrigérant de telle sorte que le flux de réfrigérant, au-delà de ladite paroi de ladite chambre de réaction, est régulé et que ladite température mesurée devient sensiblement équivalente à ladite température cible.

15. Procédé selon la revendication 14, dans lequel ledit réfrigérant est de l'air.

16. Procédé selon la revendication 14 ou 15, dans lequel l'enveloppe est une portion d'un logement pour ladite chambre de réaction.

17. Procédé selon l'une des revendications 14 à 16, dans lequel ladite étape de réglage comprend, en outre, les étapes suivantes :
le calcul d'un signal d'erreur représentant la différence entre ladite température mesurée et ladite température cible ; et
la commande, en réponse audit signal d'erreur, du dispositif de commande du flux de réfrigérant de telle sorte que ledit signal d'erreur soit réduit à un minimum.

18. Procédé selon l'une des revendications 14 à 17, dans lequel ledit dispositif de commande du flux de réfrigérant est un contrôleur de dosage à ailette.

19. Procédé selon la revendication 18, dans lequel ladite étape de calcul comprend, en outre, les étapes suivantes :
la fourniture dudit signal d'erreur à un circuit de commande moteur ;
la génération, au sein dudit circuit de commande moteur, d'un signal de commande moteur qui réagit audit signal d'erreur ;
l'activation, en réponse audit signal de commande moteur, d'un moteur qui est couplé audit contrôleur de dosage à ailette de telle sorte que ledit contrôleur de dosage à ailette soit positionné pour réguler ledit flux d'air et réduire ledit signal d'erreur à un minimum.

20. Procédé de commande de la température d'une paroi d'une chambre de réaction, selon la revendication 15, la chambre étant pourvue d'une enveloppe pour canaliser un courant de réfrigérant au-delà de ladite paroi, ledit procédé comprenant, en outre, les étapes suivantes :
la détection de la température de la paroi avec ledit thermocouple protégé ;
la génération d'un premier signal représentant ladite température de paroi détectée ;
la fourniture d'un second signal représentant ladite température de paroi cible ;
la comparaison desdits premier et second signaux ;
la génération, en réponse à ladite comparaison, d'un signal d'erreur représentant la différence entre ladite température de paroi détectée et ladite température de paroi cible ;
procédé dans lequel le réglage d'un dispositif de commande du flux de réfrigérant est effectué par réglage, en réponse audit signal d'erreur, du degré de fermeture d'une valve de commande réglable qui est positionnée pour commander le degré de flux d'un courant de réfrigérant au travers de l'enveloppe, grâce à quoi on atteint une température de la chambre de réaction proche de la température cible.

21. Procédé selon la revendication 20, dans lequel ledit réfrigérant est de l'air.

22. Procédé selon la revendication 20 ou 21, dans lequel l'enveloppe est une portion d'un logement pour ladite chambre de réaction.

23. Procédé selon l'une des revendications 20 à 22, dans lequel ladite valve de commande réglable est un contrôleur de dosage à ailette.

24. Procédé selon la revendication 23, dans lequel ladite étape de réglage comprend, en outre, les étapes suivantes :
la fourniture dudit signal d'erreur à un circuit de commande moteur ;
la génération, au sein dudit circuit de commande moteur, d'un signal de commande moteur qui réagit audit signal d'erreur ;
l'activation, en réponse audit signal de commande moteur, d'un moteur couplé audit contrôleur de dosage à ailette de telle sorte que ledit contrôleur de dosage à ailette soit positionné pour réguler ledit flux d'air et réduire ledit signal d'erreur à un minimum.
